# EUROPEAN PATENT SPECIFICATION

(11) **EP 2 041 844 B1**
(45) Date of publication and mention of the grant of the patent: **22.08.2012**
(21) Application number: 07835982.5
(22) Date of filing: 05.07.2007
(51) Int. Cl.: H01R 13/658

(54) **ELECTRICALLY CONDUCTIVE DYNAMIC ENVIRONMENTAL SEAL**
ELEKTRISCH LEITFÄHIGE, DYNAMISCHE UMWELTDICHTUNG
JOINT ÉTANCHE ENVIRONNEMENTAL DYNAMIQUE CONDUCTEUR D'ÉLECTRICITÉ

(30) Priority: 13.07.2006 US 830591 P
(43) Date of publication of application: 01.04.2009
(73) Proprietor: RAYTHEON COMPANY, MA 02451-1449 (US)
(72) Inventor: STRAYER, James D., Huntington Beach, CA 92648 (US); BROWN, Daniel P., Long Beach, CA 90815 (US); DEAN, Patricia S., Redondo Beach, CA 90277-3482 (US)
(74) Representative: Joly, Jean-Jacques
(86) International application number: PCT/US2007/015488
(87) International publication number: WO 2008/008255

(56) References cited:
- EP-A- 0 310 945
- GB-A- 2 135 533
- US-A- 2 885 459
- US-A- 5 313 016

## Description

### BACKGROUND OF THE INVENTION

### Field of the Invention:

The present invention relates to electrical and electronic components. More specifically, the present invention relates to environmental and electromagnetic seals.

### Description of the Related Art:

Turret assemblies hang on/under multiple airborne and ground based operational platforms including, but not limited to, helicopters, unmanned aerial vehicles, fixed wing aircraft, ground and marine vehicles. As the sophistication of these turret assemblies develops with advances in technology and war-fighting capabilities, electromagnetic interference issues are continuously on the rise.

Electromagnetic interference (EMI) is electromagnetic radiation emitted by electrical circuits carrying rapidly changing signals, as a by-product of their normal operation, which causes unwanted signals (interference or noise) to be induced in other circuits. This interrupts, obstructs, or otherwise degrades or limits the effective performance of those other circuits. EMI can be induced intentionally, as in some forms of external electronic warfare or unintentionally as a result of spurious emissions and the like. EMI emissions can cause severe operational platform complications such as flight, guidance, and weapon control interference. In addition, any system emitting large EMI emissions can easily be detected, and tracked by enemy forces.

Many current turret systems are complex in design and contain numerous electrical components and assemblies. In turret systems, gimbals are typically the heart of rotational motion. These gimbals consist of two dynamic rotating components (azimuth and elevation) to accurately distinguish, track, and eliminate targets. The dynamic azimuth and elevation interfaces are bearing supported, motor driven joints that contain dynamic environmental seals. The motors are often powered with high frequency voltages that can generate extremely strong EMI emissions.

One method to suppress internally generated or externally induced EMI is a Faraday cage. A Faraday cage is an enclosure designed to exclude electromagnetic fields in an application of one of Maxwell's equations: Gauss's law. Gauss's law describes the distribution of electrical charge on an electrically conductive form, such as a sphere, a plane, a torus, a gimbal etc. Since like charges repel each other, charge will 'migrate' to the surface of the conducting form. By adding a network of conductive contacts between rotating gimbal interfaces, a Faraday cage volume can be created. As internally generated EMI approaches the inside wall of the gimbal Faraday cage volume, charge will be absorbed and transferred back to chassis ground. This absorption eliminates EMI emissions from exiting the gimbal.

Given the inherent rotational characteristics of gimbals, completing a Faraday cage volume can be difficult and expensive to accomplish. Ball bearings enable gimbals to rotate and they are generally made from low electrically conductive steel. In addition, lubricated single point bearing contacts between the inner and outer races have extremely high electrical resistance values. Electrical resistance "R", measured in Ohms Ω, is a physical material property that impedes electrical current flow. In other words, a material with a high electrical resistance value is considered a poor conductor of electricity. Conversely, a material with a low electrical resistance value is a good conductor of electricity.

In many turret systems, maximum electrical resistance values are strictly enforced by customer specifications. These values are measured from the inner turret sensor, through the gimbal (including bearings and seals), and eventually to chassis ground. In past turret systems, 1 Ω to 4 Ω was considered to be an acceptable maximum resistance value. Today less than 2.5 milli-ohms is required to meet customer/program requirements. Such a change is a 1600 fold decrease in electrical resistance.

With increasingly complicated electronics, stronger torque motors, varying materials, and the general rotational dynamics of these sophisticated turrets, EMI becomes more difficult to contain and eliminate. In addition, as enemy countermeasures continue to develop, it is necessary to suppress these radiated EMI emissions even further than before.

Hence, there is a need in the art for an improved system or method for shielding systems from electromagnetic interference.

Patent document GB-A-2135533 (ITT) dated 30 August 1984 discloses an electrical connector with an electrically shielding seal. It concerns more particularly a combined EMI/RFI shield and environmental sealing element for an electrical connector in which a helical coil spring can be partially embedded in an elastomeric ring.

Patent document US-A-2885459 (Verne Pulsifer et al.) dated 5 May 1959 discloses a gasket material for providing a gas tight seal at a joint and for preventing electrical energy of radio frequencies from escaping at joints in closed containers.

### SUMMARY OF THE INVENTION

The present invention according to claim 1 addresses the need in the art by providing a solution which increases electrical conductivity between rotating gimbal interfaces while bridging an open Faraday cage volume for EMI suppression. In accordance with the invention, a seal is taught including a base and a conductor mounted to conduct current from a source disposed on a first side of said base to a sink disposed on a second side of said base.

In the illustrative embodiment, the base is annular (ring-shaped) and fabricated of airtight, watertight and/or electrically insulating and/or conductive material such as rubber, Teflon_{®}, or silver impregnated Teflon_{®} or other suitable substance. In the illustrative embodiment, the conductor is a single strip of conductive material and the base has a recess to allow for deflection thereof. In the best mode, plural conductors are mounted within the annular base. Each conductor has a brush at each end thereof. The brushes are provided by a split at the end of each strip effective to create first and second fingers. Each strip is secured at an angle in a slot in the base and retained further by an anchor. The anchor is integral with the strip and transverse to the longitudinal axis thereof.

Hence, the inventive seal provides a novel method for creating a Faraday cage including the steps of 1) providing an electromagnetic and environmental seal comprising a ring adapted to provide an environmental seal and plural conductors mounted in the ring, each conductor being a conductive strip extending through the ring on first and second sides thereof and 2) mounting the seal in a rotary joint to provide electrical conductivity between two members connected by the joint and completing the Faraday volume.

### BRIEF DESCRIPTION OF THE DRAWINGS

Figure 1 is a perspective view of an electromagnetic and environmental seal implemented in accordance with the present teachings.
Figure 2 is a magnified view of a portion of the inner periphery of the seal of Figure 1.
Figure 3 is a perspective view sectional view of the seal of Figure 1.
Figure 4 is a simplified diagram of a theoretically ideal Faraday cage volume adapted to absorb EMI signals from internal and external sources.
Figure 5 is a simplified diagram of a Faraday cage volume with EMI transmissions due to poor joint conductivity.
Figure 6 is a sectional view of the inventive environmental and electrical seal in context in an illustrative application of the present teachings.

### DESCRIPTION OF THE INVENTION

Illustrative embodiments and exemplary applications will now be described with reference to the accompanying drawings to disclose the advantageous teachings of the present invention.

While the present invention is described herein with reference to illustrative embodiments for particular applications, it should be understood that the invention is not limited thereto. Those having ordinary skill in the art and access to the teachings provided herein will recognize additional modifications, applications, and embodiments within the scope thereof and additional fields in which the present invention would be of significant utility.

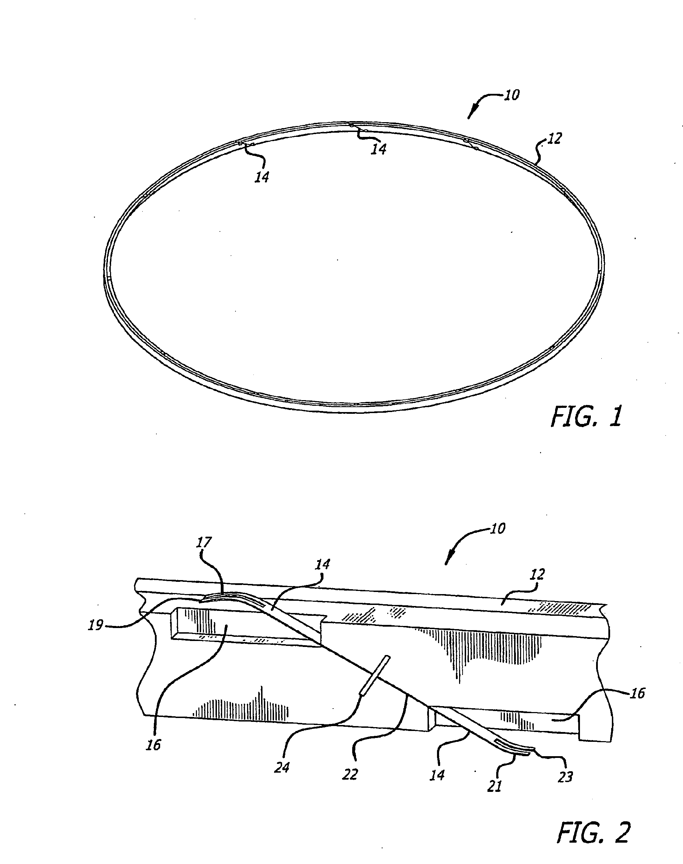

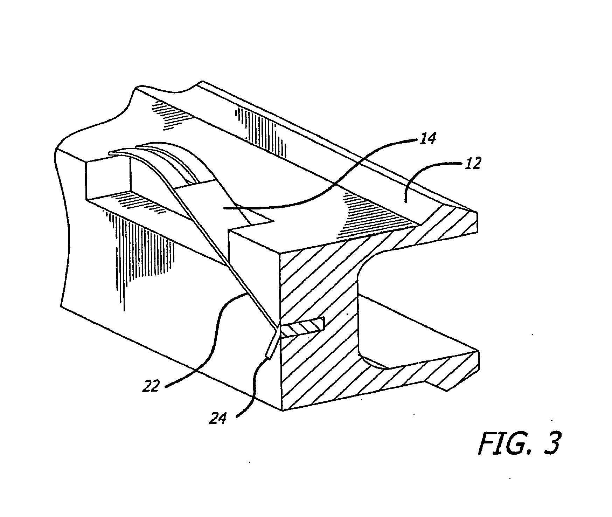

Figure 1 is a perspective view of an electromagnetic and environmental seal implemented in accordance with the present teachings. Figure 2 is a magnified view of a portion of the inner periphery of the seal of Figure 1. Figure 3 is a perspective view sectional view of the seal of Figure 1.

As shown in Figures 1 - 3, the seal 10 includes an annular base 12 and a plurality of conductors 14 mounted therein to conduct current from a source disposed on a first side of the base to a sink disposed on a second side of the base. The seal shape may vary based on multiple factors including, but not limited to, physical size between two rotating sealing surfaces, desired seal location within an assembly, desired or undesired friction, allowable environmental contaminate leak rate, etc. The seal may be made from numerous electrically conductive and/or nonconductive materials including, but not limited to, graphite filled polytetraflouroethylene, fluorosilicone, rubber, etc. The seal may be spring reinforced with a conductive or non-conductive base material structure.

The conductive strips serve to greatly increase electrical conductivity between two rotating interfaces and provide a bridge to seal open Faraday cage volumes (such as in rotating gimbal components). In the illustrative embodiment, each conductor 14 is a single strip of conductive material and the base 12 has a recess therein 16, to allow for deflection thereof. The conductors may be made from any compliant electrically conductive material, e.g., gold, silver, nickel coated spring steel, etc. The number of conductors required is based on numerous considerations such as desired electrical conductivity between two rotating interfaces, desired or undesired surface friction, physical limits of size, EMI suppression requirements, EMI wavelength or frequency, etc. The conductors may be joined to the environmental seal via numerous fastening processes including, but not limited to, press fit, clamping, vulcanization, soldering, bonding, etc.

The dimensions of the seal, the electrically conductive strips, and fingertips will vary depending on the requirements of the application.

Each conductive strip 14 may be split into multiple fingertips 17, 19, 21, 23 of varying quantity acting as a brush shown at each end thereof. Each strip 14 is secured at an angle in a slot 22 in the base and may be retained further by an anchor 24.

As mentioned above, one method to suppress system generated EMI is a Faraday cage. A Faraday cage is an enclosure designed to exclude electromagnetic fields in an application of one of Maxwell's equations: Gauss's law. Gauss's law describes the distribution of electrical charge on an electrically conductive form, such as a sphere, a plane, a torus, a gimbal etc. Since like charges repel each other, charge will 'migrate' to the surface of the conducting form. By adding a network of conductive contacts between rotating gimbal interfaces, a Faraday cage volume can be created.

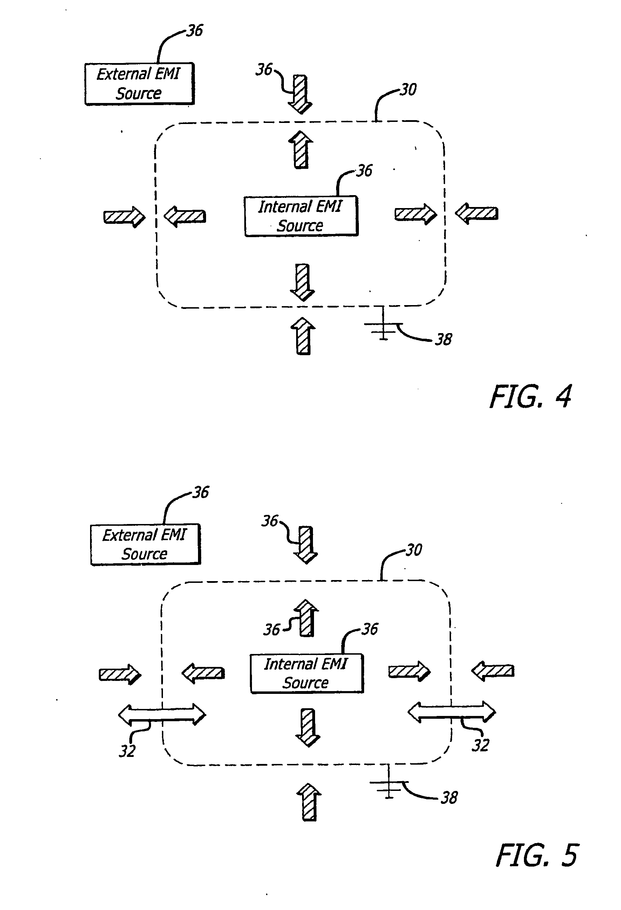

Figure 4 is a simplified diagram of a theoretically ideal Faraday cage volume adapted to absorb EMI signals and prohibit emissions. Figure 5 is a simplified diagram of a Faraday cage volume with outgoing and incoming EMI emissions due to poor joint conductivity.

As illustrated in Figure 4, as internally or externally generated EMI 36 approaches the theoretically ideal Faraday cage volume 30, charge will be absorbed and transferred back to chassis ground 38. This absorption eliminates EMI emissions from exiting or entering the gimbal.

Unfortunately, given the inherent rotational characteristics of gimbals, completing a Faraday cage volume can be difficult and expensive to accomplish. Ball bearings enable gimbals to rotate and they are generally made from low electrically conductive steel. In addition, lubricated single point bearing contacts between the inner and outer races have extremely high electrical resistance values. Electrical resistance "R", measured in Ohms Ω, is a physical material property that impedes electrical current flow. In other words, a material with a high electrical resistance value is considered a poor conductor of electricity. Conversely, a material with a low electrical resistance value is a good conductor of electricity.

In many turret systems, maximum electrical resistance values are strictly enforced by customer specifications. These values are measured from the inner sensor, through the gimbal (including bearings and seals), and eventually to chassis ground. In past systems, 1 Ω to 4 Ω was considered to be an acceptable maximum resistance value. Today less than 2.5 milli-ohms is required to meet customer/program requirements. Such a change is a 1600 fold decrease in electrical resistance.

With increasingly complicated electronics, stronger torque motors, varying materials, and the general rotational dynamics of these sophisticated turrets, EMI becomes more difficult to contain and eliminate. In addition, as enemy countermeasures continue to develop, it is necessary to suppress these radiated and received EMI emissions even further than before.

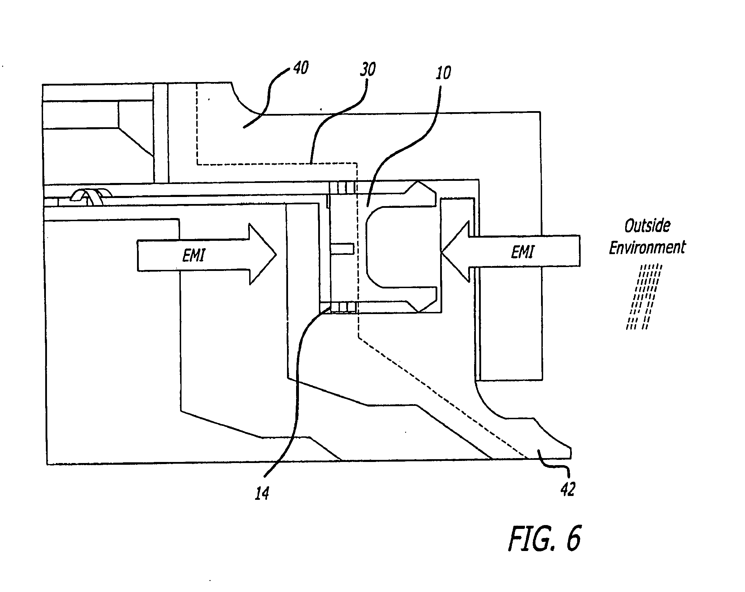

In short, in practice, as depicted in Figure 5, Faraday cage volumes 30 are opened/degraded due to rotating gimbal interfaces 32 via bearings and seals as a result of the low electrical conductivity thereof. The invention provides a low cost, easy to replace, highly electrically conductive, dynamic environmental seal that protects against environmental elements and bridges an open Faraday volume gap. This is illustrated in Figure 6.

Figure 6 is a sectional view of the inventive environmental and electrical seal in context in an illustrative application of the present teachings. As shown in Figure 6, the highly conductive environmental seal 10 of the present invention is disposed between a static base component 40 and a dynamic rotating component such as the yoke of a gimbal 42. The conductive strips 14 ensure a good electrical connection between the static and dynamic components 40 and 42 effective to create a Faraday volume 30 with minimal EMI leakage and penetration. Hence, internally generated EMI or external EMI exposure is absorbed by electrical conductivity between components 40 and 42.

Hence, the inventive seal provides a novel method for creating a Faraday cage including the steps of 1) providing an electromagnetic and environmental seal comprising a ring adapted to provide an environmental seal and plural conductors mounted in the ring, each conductor being a conductive strip extending through the ring on first and second sides thereof and 2) mounting the seal in a rotary joint to provide electrical conductivity between two members connected by the joint and completing the Faraday volume.

These conductive seals may be used in multiple applications to increase electrical conductivity and suppress outgoing or incoming EMI emissions between static and dynamic sides of a rotating joint. The invention may be used in numerous civilian or military platforms. Examples of system use would include Electro Optical FLIR systems, gun turrets, missile turrets, laser turrets, sensor turrets, EMI sensitive equipment and other unspecified uses herein.

Thus, the present invention has been described herein with reference to a particular embodiment for a particular application. Those having ordinary skill in the art and access to the present teachings will recognize additional modifications applications and embodiments within the scope thereof.

It is therefore intended by the appended claims to cover any and all such applications, modifications and embodiments within the scope of the present invention.

## Claims

1. An electromagnetic and environmental seal (10) for being placed between two rotating interfaces, **characterized in that** it comprises:
a ring (12) adapted to provide an environmental seal and
plural conductors (14) mounted in said ring (12), each conductor (14) being a conductive strip extending through said ring (12) on first and second sides thereof,
wherein each strip (14) has a brush at each end thereof.

2. The invention of Claim wherein said ring (12) is fabricated with an insulator.

3. The invention of Claim 2 wherein said insulator is rubber.

4. The invention of Claim 3 wherein said insulator is polytetrafluoroethylene.

5. The invention of Claim 1 wherein said ring (12) has recesses therein to allow for deflection of said conductors (14).

6. The invention of Claim 1 wherein each blush is provided by a split at the end of each strip effective to create first and second fingers (17, 19; 21, 23).

7. The invention of Claim 1 wherein each strip (14) includes an anchor (24).

8. The invention of Claim 1 wherein each strip (14) is secured in a slot (22) in said ring (12).

9. The invention of Claim 1 wherein said strip (14) is secured in an angle in said ring (12).

## Patentansprüche

1. Elektromagnetische und Umgebungsdichtung (10) zum Anordnen zwischen zwei rotierenden Kontaktflächen, **dadurch gekennzeichnet, daß** sie umfaßt:
einen Ring (12), der dazu angepaßt ist, eine Umgebungsdichtung bereitzustellen, und
mehrere in dem Ring (12) angebrachte Leiter (14), wobei jeder Leiter (14) ein leitender Streifen ist, der sich durch ring (12) auf ersten und zweiten Seiten davon erstreckt,
wobei jeder Streifen (14) eine Bürste an jedem Ende davon aufweist.

2. Erfindung nach Anspruch 1, wobei der Ring (12) mit einem Isolator gefertigt ist.

3. Erfindung nach Anspruch 2, wobei der Isolator Gummi ist.

4. Erfindung nach Anspruch 3, wobei der Isolator Polytetrafluorethylen ist.

5. Erfindung nach Anspruch 1, wobei der Ring (12) Ausschnitte darin aufweist, um eine Auslenkung der Leiter (14) zu erlauben.

6. Erfindung nach Anspruch 1, wobei jede Bürste mit einer Aufspaltung am Ende des jeweiligen Streifens versehen ist, um erste und zweite Finger (17, 19; 21, 23) zu bilden.

7. Erfindung nach Anspruch 1, wobei jeder Streifen (14) einen Anker (24) enthält.

8. Erfindung nach Anspruch 1, wobei jeder Streifen (14) in einem Schlitz (22) in dem Ring (12) befestigt ist.

9. Erfindung nach Anspruch 1, wobei der Streifen (14) in einem Winkel in dem Ring (12) befestigt ist.

## Revendications

1. Joint électromagnétique et environnemental (10) destiné à être placé entre deux interfaces rotatives, **caractérisé en ce qu'**il comprend :
une bague (12) conçue pour réaliser un joint environnemental ; et
plusieurs conducteurs (14) montés dans ladite bague (12), chaque conducteur (14) étant une bande conductrice s'étendant à travers ladite bague (12) sur des premier et deuxième côtés de celle-ci,
dans lequel chaque bande (14) comporte une brosse à chaque extrémité de celle-ci.

2. Invention selon la revendication 1, dans laquelle ladite bague (12) est fabriquée avec un isolant.

3. Invention selon la revendication 2, dans laquelle ledit isolant est du caoutchouc.

4. Invention selon la revendication 3, dans laquelle ledit isolant est du polytétrafluroéthylène.

5. Invention selon la revendication 1, dans laquelle ladite bague (12) comporte des évidements dans celle-ci pour permettre la déflexion desdits conducteurs (14).

6. Invention selon la revendication 1, dans laquelle chaque brosse est réalisée par une division à l'extrémité de chaque bande efficace pour créer des premier et deuxième doigts (17, 19 ; 21, 23).

7. Invention selon la revendication 1, dans laquelle chaque bande (14) comprend un élément d'ancrage (24).

8. invention selon la revendication 1, dans laquelle chaque bande (14) est fixée dans une fente (22) dans ladite bague (12).

9. Invention selon la revendication 1, dans laquelle ladite bande (14) est fixée selon un angle dans ladite bague (12),
